# EUROPEAN PATENT APPLICATION

(11) **EP 4 316 678 A1**
(43) Date of publication of application: **07.02.2024**
(21) Application number: 22828250.5
(22) Date of filing: 10.06.2022
(51) Int. Cl.: B08B 3/04, C11D 1/72, C11D 3/20, C11D 3/28, G03F 7/42, H05K 3/06

(54) **RELEASE AGENT FOR CIRCUIT BOARD RESIN FILM AND PRODUCTION METHOD FOR CIRCUIT BOARD**

(30) Priority: 24.06.2021 JP 2021104677
(71) Applicant: NOF Corporation, Shibuya-ku Tokyo 150-6019 (JP)
(72) Inventor: EZUKA, Hiroki, Amagasaki-shi, Hyogo 660-0095 (JP); FUJITA, Hiroya, Amagasaki-shi, Hyogo 660-0095 (JP)
(74) Representative: Isarpatent
(86) International application number: PCT/JP2022/023448
(87) International publication number: WO 2022/270333

(57) **Abstract**

A release agent for a circuit board resin film being able to release a resin film formed on a circuit board in a short amount of time, having a high resin film fragmentation performance, and having a low environmental burden, is provided. The release agent contains a compound (component (A)) shown in formula (1) and a fatty alcohol (component (B)) having a carbon number of 1-6 and a molecular weight of 30-120, wherein the pH is 13.0-14.0, the content of component (A) is 0.1-5 mass%, and the content of component (B) is 5-40 mass%. Formula (1): R¹-O-(A¹O)a-H, wherein R¹ represents a branched alkyl group having a carbon number of 6-10, A¹O represents an oxyalkylene group having a carbon number of 2-3, and a, which is the average number of added moles of the oxyalkylene group, is from 2 to 15.

## Description

### Technical Field

The present invention relates to a removal agent for a resin film for a circuit board (herein simply referred to as "circuit board resin film") and a method for producing the circuit board.

### Background Art

In recent years, in the field of electronic information devices, technological advances have been made for reducing the size and weight of electronic devices and for enabling large-capacity communication. In order to enable these technological advances, research is underway to improve the precision of electronic circuit components. An electronic circuit component is formed by exposure patterning using a photosensitive resin. For improving precision of electronic circuit components, the photosensitive resin is required to have improved photoreactivity and strength after curing so as to enable fine exposure patterning. On the other hand, such a photosensitive resin is also required to be easily removed from a substrate after the exposure patterning process. However, it is difficult to achieve both high strength after curing and high removability from a substrate after the exposure patterning process.

Conventionally, a removal agent containing an amine compound, such as quaternary ammonium hydroxide, has been used to remove a photosensitive resin from a substrate. A removal agent containing an amine compound has the problem such that it is highly toxic and has high environmental impact. Therefore, there is a demand for the development of a method for increasing the removability of the photosensitive resin by using an alternative alkaline removal agent.

For example, Patent Literature (hereinafter, referred to as PTL) 1 describes a water-based removal solution (removal agent) for removing a photoresist (photosensitive resin) applied onto a substrate where a conductive metal film containing aluminum, silver, or the like is formed. The removal solution contains a surfactant, an anti-corrosion agent, and a water-soluble organic solvent.

PTL 2 describes a water-based cleaning composition for removing resin masks, containing an inorganic alkali, a polyhydric alcohol, and an additional organic solvent.

PTL 3 describes a cleaning composition for removing resin masks, containing an inorganic alkali and a surfactant having an ethyleneoxy group.

### Citation List

### Patent Literature

PTL 1
   Japanese Patent Application Laid-Open No. 2008-58624
PTL 2
   Japanese Patent Application Laid-Open No. 2019-117331
PTL 3
   Japanese Patent Application Laid-Open No. 2019-105670

### Summary of Invention

### Technical Problem

From the findings of the present inventors, there is a problem such that it is difficult for the above-described alternative removal agent to satisfactorily remove the residue of the resin film because, for example, the efficiency of subdividing a resin film such as a photosensitive resin film, which is a feature of the amine compound, is insufficient.

For example, the removal agent described in PTL 1 has insufficient removability of a resin film, and a residue of the resin film may remain on a circuit board. In addition, the active ingredient of the cleaning composition described in PTL 2 does not satisfactorily permeate into a resin film, and the efficiency of subdividing the resin film is insufficient, thereby reducing the removability. Therefore, a residue of the resin film may still remain on a circuit board. Although the cleaning composition described in PTL 3 has improved permeability of the active ingredient into a resin film, the removability of the resin film is still insufficient. In order to satisfactorily remove the resin film, a long time process is required, which causes a problem of lower productivity.

The present invention has been made in view of the above circumstances. An object of the present invention is to provide a removal agent for a circuit board resin film and a method for producing a circuit board both having the following features: capable of removing a resin film formed on a circuit board in a short period of time, having high efficiency of reducing a residue on the circuit board by subdividing the resin film, and having low environmental impact. Another object of the present invention is to provide a method for producing a circuit board by using the removal agent.

### Solution to Problem

A removal agent for a circuit board resin film in one aspect of the present invention for solving the above problems contains a compound (component (A)) represented by formula (1) below and an aliphatic alcohol (component (B)) having 1 or more and 6 or less (herein referred to as "1 to 6") carbon atoms and a molecular weight of 30 or more and 120 or less. The pH of the removal agent is 13.0 or more and less than 14.0, and based on the total mass of the removal agent, the content of the component (A) is 0.1 mass% or more and 5 mass% or less, and the content of the component (B) is 5 mass% or more and 40 mass% or less.

R¹-O-(A¹O)a-H ... formula (1)

In formula (1), R¹ represents a branched alkyl group having 6 to 10 carbon atoms, A¹O represents an oxyalkylene group having 2 to 3 carbon atoms, and a representing an average addition mole number of the oxyalkylene group (i.e., average number of moles of the oxyalkylene group added) is 2 or more and 15 or less.

A method for producing a circuit board in another aspect of the present invention for solving the above problems includes preparing a circuit board with a resin film formed on at least one surface thereof, and bringing the removal agent into contact with the resin film.

### Advantageous Effects of Invention

The present invention can provide a removal agent for a circuit board resin film and a method for producing a circuit board both having the following features: capable of removing a resin film formed on a circuit board in a short period of time, having high efficiency of reducing a residue on the circuit board by subdividing the resin film, and having low environmental impact. The present invention can also provide a method for producing a circuit board by using the removal agent.

### Description of Embodiment

Hereinafter, at least one embodiment of the present invention will be described.

A removal agent for a circuit board resin film (herein also simply referred to as "removal agent") relating to one embodiment of the present invention contains a compound (component (A)) represented by formula (1) and an aliphatic alcohol (component (B)) having 1 to 6 carbon atoms and a molecular weight of 30 or more and 120 or less. The pH of the removal agent is 13.0 or more and less than 14.0.

R¹-O-(A¹O)a-H ... formula (1)

In formula (1), R¹ represents a branched alkyl group having 6 to 10 carbon atoms, A¹O represents an oxyalkylene group having 2 to 3 carbon atoms, and a representing an average addition mole number of the oxyalkylene group is 2 or more and 15 or less.

Each component contained in the removal agent will be described below.

### Component (A)

The component (A) is a compound (polyalkylene glycol) represented by formula (1). The component (A) can sufficiently subdivide a circuit board resin film (hereinafter also simply referred to as "resin film") to facilitate the removal, and can reduce the residue on the circuit board.

R¹-O-(A¹O)a-H ... formula (1)

In formula (1), R¹ represents a branched alkyl group having 6 to 10 carbon atoms. R¹ is preferably a branched alkyl group having 8 to 9 carbon atoms. When R¹ is a branched alkyl group having 6 to 10 carbon atoms, the component (A) is more likely to permeate a resin film, the resin film is sufficiently subdivided to facilitate the removal of the film, and the residue on the circuit board can be reduced. In addition, the removal agent is less likely to foam and the stability of the removal agent during storage is also further increased.

In particular, the component (A) with R¹ of a branched alkyl group can further increase the removal efficiency of the resin film. From the above viewpoint, the branched chain in R¹ is preferably an alkyl group having 1 to 3 carbon atoms, more preferably a methyl branch or an ethyl branch.

Specific examples of R¹ include isooctyl group, 2-ethylhexyl group, isononyl group, 3,5,5-trimethylhexyl group, and isodecyl group.

In formula (1), A¹O represents an oxyalkylene group having 2 to 3 carbon atoms. A¹O may contain only oxyethylene group, may contain only oxypropylene group, or may contain both oxyethylene group and oxypropylene group. A¹O preferably contains only oxyethylene group or both oxyethylene and oxypropylene groups.

When A¹O contains both oxyethylene and oxypropylene groups, A¹O preferably has a structure such that oxyethylene group (EO group) alone or oxyethylene group forming a block and oxypropylene group (PO group) alone or oxypropylene group forming a block are added in the order of R¹-O-EO group(s)-PO group(s)-H. The component (A) in which R¹O has such a structure has a particularly high permeability to a resin film, and can subdivide the resin film more finely and remove the resin film, thereby reducing the residue on the circuit board.

In formula (1), a is the average addition mole number of the oxyalkylene group (A¹O) and is 2 or more and 15 or less. It is preferable that a is 4 or more and 7 or less. When A¹O is composed only of oxyethylene group, a is preferably 2 or more and 10 or less, when A¹O is composed only of oxypropylene group, a is preferably 2 or more and 6 or less, and when A¹O contains both oxyethylene and oxypropylene groups, a is preferably 5 or more and 10 or less.

When A¹O contains both oxyethylene and oxypropylene groups, and when a' is defined as the average addition mole number of the oxyethylene group and a" is defined as the average addition mole number of the oxypropylene group, a'/a" is preferably 0.5 or more and 1.5 or less. The component (A) having a'/a" within the above range has higher permeability into the resin film, and can further reduce the residue on the circuit board. In addition, the component (A) having a'/a" within the above range is less likely to allow the removal agent to foam, thereby reducing the impact of the removal agent on the surrounding environment, and reducing the load on the apparatus used to further increase the productivity.

The removal agent may contain only one type or a plurality of types of compounds represented by formula (1) as the component (A); however, from the viewpoint of removal efficiency, the removal agent preferably contains a plurality of types of compounds represented by formula (1).

When the removal agent contains a plurality of compounds represented by formula (1), it is more preferably to combine a component (a1) with R¹ that is a branched alkyl group having 6 to 8 carbon atoms and a component (a2) with R¹ that is a branched alkyl group having 9 or 10 carbon atoms. It is more preferable to combine a component with a branched alkyl group having 8 carbon atoms and a component with a branched alkyl group having 9 carbon atoms.

When components (a1) and (a2) are combined, the ratio of (a1) and (a2) in mass ratio ((a1)/(a2)) is preferably 99/1 to 40/60, more preferably 98/2 to 50/50, even more preferably 98/2 to 75/25, and particularly preferably 97/3 to 80/20.

The HLB value of the component (A) is not limited, and may be, for example, 5 or more and 13 or less.

The content of the component (A) based on the total mass of the removal agent is 0.1 mass% or more and 5 mass% or less, preferably 0.5 mass% or more and 5 mass% or less, and more preferably 1 mass% or more and 2 mass% or less. When the content of the component (A) is 0.1 mass% or more, the permeability of the removal agent to the resin film can be increased, and the residue on the circuit board can be further reduced. When the content of the component (A) is 10 mass% or less, the stability of the removal agent during storage is further increased.

### Component (B)

The component (B) is an aliphatic alcohol having 1 to 6 carbon atoms and a molecular weight of 30 or more and 120 or less. The component (B) can increase the removability of a resin film from a circuit board, while the component (B) is less likely to allow the removal agent to foam and increases the stability of the removal agent during storage.

The removal agent may contain only one type or a plurality of types of aliphatic alcohols as the component (B); however, from the viewpoint of efficiency of subdividing, the removal agent preferably contains a plurality of types of aliphatic alcohols.

When the removal agent contains a plurality of aliphatic alcohols, it is more preferably to combine a component (b1) having one hydroxyl group in the molecule and a component (b2) having two or more hydroxyl groups in the molecule. It is more preferable to combine a component having one hydroxyl group and a component having three hydroxyl groups.

When components (b1) and (b2) are combined, the ratio of (b1) and (b2) in mass ratio ((b1)/(b2)) is preferably 99/1 to 80/20, more preferably 98/2 to 85/15, and particularly preferably 97/3 to 90/10.

The component (B) is preferably a water-soluble alcohol. In addition, the component (B) may have an alicyclic structure or may have a non-alicyclic (linear or branched) structure. Furthermore, the component (B) may have an ether structure in the molecule. The component (B) has one or more hydroxyl groups in the molecule. The number of hydroxyl groups in the molecule of the component (B) is not limited, but preferably 1 or more and 3 or less.

Examples of the component (B) include methanol, ethanol, isopropyl alcohol, ethylene glycol, diethylene glycol, glycerin, 1,2-butanediol, 1,3-butanediol, 1,4-butanediol, 2,3-butanediol, ethylene glycol monomethyl ether, ethylene glycol monoethyl ether, ethylene glycol monobutyl ether, 3-methoxy-1-butanol, 3-methoxy-3-methyl-1-butanol, and tetrahydrofurfuryl alcohol.

In particular, 3-methoxy-3-methyl-1-butanol, tetrahydrofurfuryl alcohol, glycerin, diethylene glycol, and methanol are preferred, and 3-methoxy-3-methyl-1-butanol and glycerin are more preferred.

The content of the component (B) based on the total mass of the removal agent is 5 mass% or more and 40 mass% or less, preferably 5 mass% or more and 35 mass% or less, and more preferably 5 mass% or more and 30 mass% or less. When the content of the component (B) is 5 mass% or more, the resin film can be sufficiently subdivided. When the content of the component (B) is 40 mass% or less, the removability of a resin film and efficiency of subdividing the resin film are increased, and the stability of the removal agent during storage is also further increased.

### Component (C)

The removal agent may contain an antirust agent (component (C)) in addition to the components described above. The component (C) can further improve the effects of the present invention.

The removal agent may contain only one type or a plurality of types of antirust agents as the component (C).

The type of antirust agent is not limited, and a known antirust agent having an imidazole ring, pyrazole ring, oxazole ring, thiazole ring, triazole ring, tetrazole ring, or the like can be used.

From the viewpoint of increasing the removability of a resin film, the component (C) is preferably a compound having a triazole ring, more preferably a compound having a benzotriazole structure, even more preferably a compound represented by formula (2).

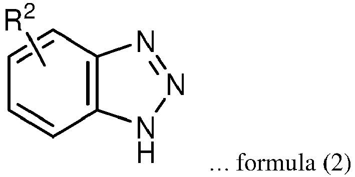

In formula (2), R² represents a hydrogen atom, a methyl group, or a carboxyl group. In particular, R² is preferably a hydrogen atom or a carboxyl group, more preferably a hydrogen atom from the viewpoint of increasing the water solubility of the component (C) and the removability of the resin film.

The content of the component (C) based on the total mass of the removal agent is not limited, but preferably 0.5 mass% or more and 2 mass% or less, more preferably 0.5 mass% or more and 1.5 mass% or less, and even more preferably 1.0 mass% or more and 1.5 mass% or less. When the content of the component (C) is 0.5 mass% or more, the stability of the removal agent during storage is increased. When the content of the component (C) is 0.5 mass% or more, the resin film can be sufficiently subdivided to facilitate the removal of the film, and the residue on the circuit board can be reduced. When the content of the component (C) is 2 mass% or less, the removal agent is less likely to foam. In addition, when the content of the component (C) is 2 mass% or less, the stability of the removal agent during storage is further increased. Further, when the content of the component (C) is 2 mass% or less, the resin film can be sufficiently subdivided to facilitate the removal of the film, and the residue on the circuit board can be reduced.

### The pH and Alkaline Component

The pH of the removal agent is 13.0 or more and 14.0 or less, preferably 13.2 or more and 13.8 or less, and more preferably 13.4 or more and 13.6 or less. When the pH is within the above range, the removability of the resin film is sufficiently increased. The pH of the removal agent can be adjusted within the above range by adding a known alkaline component.

The alkaline component is a water-soluble compound and when dissolved in water, changes the resultant aqueous solution to alkaline. The alkaline component may be an organic alkaline component containing at least one carbon atom in the molecule, or may be an inorganic alkaline component containing no carbon atoms in the molecule.

The removal agent may contain only one type or a plurality of types of alkaline components for adjusting the pH.

Examples of the organic alkaline component include monoethanolamine, diethanolamine, and triethanolamine. Examples of the inorganic alkaline components include sodium hydroxide, potassium hydroxide, lithium hydroxide, calcium hydroxide, sodium carbonate, potassium carbonate, sodium silicate, and potassium silicate.

The alkaline component is preferably sodium hydroxide, potassium hydroxide, sodium carbonate, or potassium carbonate, more preferably sodium hydroxide or potassium hydroxide, from the viewpoint of further increasing the removability of the resin film.

### Additional Component

In addition to the components described above, the removal agent may contain additional components generally added in conventional removal agents for circuit board resin films. Examples of the above additional component to be added may include preservatives, thickeners, and colorants.

### Preparation of Removal Agent

A removal agent may be prepared by a known method in which the above components are diluted with water to be at appropriate concentrations to obtain an aqueous solution. As the water used for dilution, ion-exchanged water, distilled water, RO water, tap water, industrial water, or the like may be used.

The content of the water based on the total mass of the removal agent is preferably 50 mass% or more, more preferably 60 mass% or more, and even more preferably 70 mass% or more. The content of the water is not limited, but preferably 90 mass% or less.

### Use of Removal Agent

During a known method of producing a circuit board, a removal agent is used to remove a resin film, which is temporarily formed on the surface of the circuit board, after necessary processing is performed.

In other words, a method for producing such a circuit board includes the following steps: forming a resin film on at least one surface of a circuit board; processing the circuit board with the resin film formed on the at least one surface thereof; and removing the resin film from the processed circuit board by using a removal agent.

The resin film formed on the surface of the circuit board may be a negative resin film, which is cured by external stimuli such as light and heat, or a positive resin film, which dissolves due to the external stimuli. The resin film is preferably a negative resin film. Examples of the negative resin film include a negative dry film resist and a negative liquid resist. By forming a fine pattern on the resin film by these external stimuli (specifically, exposure and development), the circuit board can be finely processed with the use of the obtained patterned resin film as a mask (protective film). The method for processing the circuit board is not limited, and known methods such as laser irradiation and etching can be used.

Thereafter, by bringing the removal agent into contact with the resin film, the resin film after the processing can be removed. The contact may be performed by a known method such as immersing the circuit board in a removal solution or spraying the removal solution onto the circuit board.

It is considered that the removal agent dissolves the resin film at the interface between the circuit board and the resin film or permeates the resin film to swell the resin film to reduce the adhesion at the interface between the circuit board and the resin film, thereby removing the resin film. In order to sufficiently provide these effects, it is preferable to allow the removal agent to sufficiently permeate the resin film in such a way that a sufficient amount of the removal agent reaches the interface between the circuit board and the resin film. Furthermore, the removal agent subdivides the resin film by the permeation, which is also considered to facilitate the removal of the resin film.

The temperature of the removal agent when the removal agent is brought into contact with the resin film is preferably about 20 to 60°C.

### Examples

Hereinafter, the present invention will be described with reference to Examples and Comparative Examples; however, the present invention is not limited to the following Examples.

### 1. Preparation of Removal Agents

### 1-1. Materials

### 1-1-1. Alcohol having a structure represented by formula (1)

Compounds A1, A2, and A1' shown in Table 1 were prepared. The compounds A1 and A2 are each a compound (component (A)) represented by formula (1). The compound A1' has a structure represented by formula (1) but is not component (A) because R¹ is different.

R¹-O-(A¹O)a-H ... formula (1)

For the compounds A1, A2, and A1', Table 1 shows the structure of R¹ in formula (1) (functional group name), the number of carbon atoms in R¹, the structure of A¹O, the numbers of EO groups and PO groups (average values), the value of a'/a" (the number of EO groups (average value) / number of PO groups (average value)), and number of a (average value).

**Table 1**

| Compound | R¹ | | A¹O | | | | a |
|---|---|---|---|---|---|---|---|
| | Functional group name | Carbon atom number | Structure | Number of EO groups | Number of PO groups | a'/a" | |
| A1 | 2-Ethylhexyl group | 8 | EO | 4 | | | 4 |
| A2 | 3,5,5-Trimethylhexyl group | 9 | EO/PO | 4 | 3 | 1.3 | 7 |
| A1' | Dodecyl group | 12 | | | | | 0 |

### 1-1-2. Organic solvent

Compounds B 1 to B5 and B 1' shown in Table 2 were prepared. The compounds B 1 to B5 are each an aliphatic alcohol (component (B)) having 1 to 6 carbon atoms and a molecular weight of 30 or more and 120 or less. The compound B 1' is an organic solvent that is not component (B).

For the compounds B1 to B5 and B1', Table 2 shows the compound name, the molecular weight, the number of carbon atoms, and the number of hydroxyl groups.

**Table 2**

| Compound | Compound name | Molecular weight | Carbon atom number | Number of hydroxyl groups |
|---|---|---|---|---|
| B1 | 3-Methoxy-3-methyl-1-butanol | 118 | 6 | 1 |
| B2 | Tetrahydrofurfuryl alcohol | 102 | 5 | 1 |
| B3 | Glycerin | 92 | 3 | 3 |
| B4 | Diethylene glycol | 62 | 4 | 2 |
| B5 | Methanol | 32 | 1 | 1 |
| B1' | Diethylene glycol monobutyl ether | 162 | 1 | 1 |

### 1-1-3. Antirust agent

Benzotriazole was prepared. Benzotriazole is a compound (component (C)) in which R² in formula (2) is H.

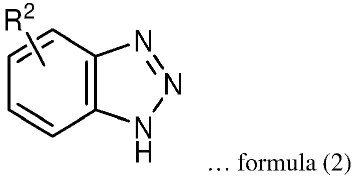

### 1-1-4. Alkaline component

Compounds D1 to D3 shown in Table 3 were prepared. Compounds D1 to D3 are each an alkaline component (component D).

Table 3 shows the compound names of the compounds D1 to D3.

**Table 3**

| Compound | Compound name |
|---|---|
| D1 | Sodium hydroxide |
| D2 | Potassium hydroxide |
| D3 | Monoethanolamine |

### 1-2. Preparation of Removal Agents

The above-described components were dissolved in water, and water was further added so that the total amount becomes 100 mass% to obtain water-based removal agents 1 to 15 for circuit board resin films and water-based removal agents 21 to 28 for circuit board resin films.

### 1-3. Measurement of pH

The pH of removal agents 1 to 15 and removal agents 21 to 28 was measured by using a pH meter ("LAQUA F-72," manufactured by Horiba, Ltd.). The measurement temperature was set at 25°C, and the pH was measured while each removal agent was stirred in a constant temperature bath at 25°C.

### 2. Evaluation of Removal Agents

Removal agents 1 to 15 and removal agents 21 to 28 prepared above were evaluated according to the following criteria.

### 2-1. Removal Test

### 2-1-1. Formation of circuit board resin films

A photosensitive film for a PCB circuit (manufactured by Guang Zhou TiYaLin Electronic Technology Co., Ltd.) was used as a resin film for an integrated circuit. This film is a negative dry film resist.

An oxygen-free copper plate ("oxygen-free copper plate," manufactured by TP Giken Co., Ltd., length × width × thickness = 50 × 15 × 1 mm) was used as an electronic circuit board. The negative dry film resist was applied onto the electronic circuit board. Specifically, the negative dry film resist was processed to a predetermined size (length × width = 20 × 15 mm), the protective film on one surface of the film was peeled off, and the surface (from which the protective film was removed) was adhered to the electronic circuit board. The copper plate with the negative dry film resist adhered thereto was thermocompression bonded for 30 seconds at 100°C by using a hot plate. Thereafter, the surface (on which the negative dry film resist was thermocompressed) of the electronic circuit board was irradiated with UV (irradiation time of 120 second and total light dose of about 22 mW) by using a UV spot light source ("LIGHTNING CURE LC6" manufactured by Hamamatsu Photonics K.K.), thereby curing the negative dry film resist to obtain a circuit board with a resin film (circuit board resin film) formed thereon.

### 2-1-2. Removal test (evaluations for removing and subdividing)

The circuit board coated with the negative dry film resist was completely immersed in about 50 g of one of the removal agent prepared above in a 50 ml screw tube. While the circuit board was stirred in the screw tube at 500 rpm, the time until it was visually confirmed that the resin film was completely removed was measured. In addition, several removed test pieces were randomly taken out from the removal agent, the lengths of four sides (herein simply referred to as "four side length") of each test pieces were measured, and the average value of the measured lengths was calculated. The test removal was conducted with the liquid temperature adjusted to 50°C during the test. This series of removing steps was repeated three times.

A "removal time" by the use of a removal solution is defined as follows: the average value of the three performed tests for the time required after the circuit board was immersed in the removal solution until it was visually confirmed that the resin film was completely removed. In addition, the "four side length of a removed piece" generated by the use of a removal solution is defined as follows: the average value of the three performed tests for the average value of the four side lengths of the test pieces measured after immersing the circuit board in the removal solution.

Based on the above "removal time" and "four side length of a removed piece," each removal solution was evaluated according to the following criteria.

### (1-1) Evaluation for removing

Excellent: Removal time was less than 90 seconds
Good: Removal time was more than 90 seconds and 120 seconds or less
Poor: Removal time was more than 120 seconds

### (1-2) Evaluation for subdividing

Excellent: The average four side length of the removed pieces was 2 mm or less
Good: The average four side length of the removed pieces was more than 2 mm and 5 mm or less
Poor: The average four side length of the removed pieces was more than 5 mm

### 2-2. Test for Low Foamability

Into a 100 ml screw tube, 10 g of each removal agent before water was added to have the total amount of 100 mass% was weighed. After the lid was put on, the removal agent was vigorously shaken up and down for 10 seconds and then allowed to stand. The foam height from the liquid surface was measured after 30 seconds of standing.

Based on the foam height as measured above, each removal solution was evaluated according to the following criteria.

### (2) Low Foamability

Excellent: Foam height was 5mm or less
Good: Foam height was higher than 5mm and 10mm or less
Poor: Foam height was higher than 10mm

### 2-3. Stability Test

Into a 100 ml screw tube, 50 ml of each removal agent was put and allowed to stand in constant temperature baths of -10°C and 25°C for one week. The appearance of the removal agent after standing was observed.

Based on the observed appearance of the removal agent, each removal solution was evaluated according to the following criteria.

(3) Stability
Good: At both temperatures, the removal agent was uniform and transparent after standing
Poor: At least one of the temperatures, the removal agent became cloudy after standing

Tables 4 to 8 show the content of the components contained in removal agents 1 to 15 and removal agents 21 to 28, and the pH of each removal solution. Tables 4 to 8 also show the evaluation results for each removal solution. The numerical value for each component in Tables 4 to 8 indicates the ratio (unit: mass%) of the component based on the total mass of the removal agent.

**Table 4**

| Remark | | | | Ex. 1 | Ex. 2 | Ex. 3 | Ex. 4 | Ex. 5 |
|---|---|---|---|---|---|---|---|---|
| Removal agent No. | | | | 1 | 2 | 3 | 4 | 5 |
| Removal agent | Component | Compound of formula (1) | A1 | 0.9 | 0.6 | 0.9 | 2.5 | 3 |
| | | | A2 | 0.1 | 0.4 | 0.1 | 0.5 | 2 |
| | | Organic solvent | B1 | 15 | 20 | 5 | 10 | 25 |
| | | | B2 | | | | | |
| | | | B3 | 0.5 | 1 | | | 5 |
| | | | B4 | | | | | |
| | | | B5 | | | | | |
| | | Antirust agent | C1 | | | | | |
| | | Alkaline component | D1 | 3 | 1 | 5 | | |
| | | | D2 | | | | 3 | |
| | | | D3 | 1 | | | | 3 |
| | | Water | | Balance | Balance | Balance | Balance | Balance |
| | pH | | | 13.6 | 13.5 | 13.8 | 13.8 | 13.1 |
| Evaluation results | (1) Removal | (1-1) Removability | Evaluation | Excellent | Good | Excellent | Excellent | Good |
| | | | Removal time (sec) | 80 | 118 | 74 | 86 | 110 |
| | | (1-2) Subdividing | Evaluation | Excellent | Excellent | Good | Good | Good |
| | | | Removed piece size (mm) | 1 | 1 | 4 | 5 | 4 |
| | (2) Low Foamability | | Evaluation | Excellent | Good | Excellent | Excellent | Excellent |
| | | | Foam height (mm) | 5 | 6 | 3 | 4 | 5 |
| | (3) Stability | | Evaluation | Good | Good | Good | Good | Good |

**Table 5**

| Remark | | | | Ex. 6 | Ex. 7 | Ex. 8 | Ex. 9 | Ex. 10 |
|---|---|---|---|---|---|---|---|---|
| Removal agent No. | | | | 6 | 7 | 8 | 9 | 10 |
| Removal agent | Component | Compound of formula (1) | A1 | 1 | 5 | 0.9 | 2.9 | 0.6 |
| | | | A2 | | | 0.1 | 0.1 | 0.4 |
| | | Organic solvent | B1 | 15 | 20 | | 25 | |
| | | | B2 | | | 15 | | |
| | | | B3 | 0.5 | 1 | 1 | 1 | |
| | | | B4 | | | | | 15 |
| | | | B5 | | | | | |
| | | Antirust agent | C1 | | | | | |
| | | Alkaline component | D1 | 3 | 2 | 3 | 3 | 3 |
| | | | D2 | | | | | |
| | | | D3 | 1 | | | | |
| | | Water | | Balance | Balance | Balance | Balance | Balance |
| | pH | | | 13.6 | 13.4 | 13.5 | 13.5 | 13.6 |
| Evaluation results | (1) Removal | (1-1) Removability | Evaluation | Good | Good | Good | Excellent | Good |
| | | | Removal time (sec) | 101 | 112 | 91 | 82 | 112 |
| | | (1-2) Subdividing | Evaluation | Excellent | Excellent | Excellent | Excellent | Good |
| | | | Removed piece size (mm) | 2 | 2 | 1 | 2 | 5 |
| | (2) Low Foamability | | Evaluation | Good | Excellent | Excellent | Excellent | Excellent |
| | | | Foam height (mm) | 6 | 3 | 4 | 1 | 5 |
| | (3) Stability | | Evaluation | Good | Good | Good | Good | Good |

**Table 6**

| Remark | | | | Ex. 11 | Ex. 12 | Ex. 13 | Ex. 14 | Ex. 15 |
|---|---|---|---|---|---|---|---|---|
| Removal agent No. | | | | 11 | 12 | 13 | 14 | 15 |
| Removal agent | Component | Compound of formula (1) | A1 | 1.8 | 1.5 | 0.9 | 0.9 | 3 |
| | | | A2 | 0.2 | 0.5 | 0.1 | 0.1 | 2 |
| | | Organic solvent | B1 | | 15 | 15 | 15 | 15 |
| | | | B2 | | | | | 5 |
| | | | B3 | | | 0.5 | 0.5 | |
| | | | B4 | | 1 | | | |
| | | | B5 | 20 | | | | |
| | | Antirust agent | C1 | | | 0.5 | 2 | 1 |
| | | Alkaline component | D1 | 3 | 3 | 3 | 3 | 3 |
| | | | D2 | | | | | |
| | | | D3 | | | | | |
| | | Water | | Balance | Balance | Balance | Balance | Balance |
| | pH | | | 13.6 | 13.5 | 13.6 | 13.4 | 13.5 |
| Evaluation results | (1) Removal | (1-1) Removability | Evaluation | Excellent | Good | Excellent | Excellent | Excellent |
| | | | Removal time (sec) | 89 | 118 | 70 | 81 | 77 |
| | | (1-2) Subdividing | Evaluation | Good | Excellent | Excellent | Good | Good |
| | | | Removed piece size (mm) | 5 | 1 | 1 | 4 | 3 |
| | (2) Low Foamability | | Evaluation | Excellent | Excellent | Excellent | Good | Excellent |
| | | | Foam height (mm) | 3 | 2 | 4 | 10 | 4 |
| | (3) Stability | | Evaluation | Good | Good | Good | Good | Good |

**Table 7**

| Remark | | | | Comp. Ex. 1 | Comp. Ex. 2 | Comp. Ex. 3 | Comp. Ex. 4 | Comp. Ex. 5 |
|---|---|---|---|---|---|---|---|---|
| Removal agent No. | | | | 21 | 22 | 23 | 24 | 25 |
| Removal agent | Component | Compound of formula (1) | A1 | 1 | 1 | | 10 | |
| | | | A'1 | | | | | 3 |
| | | Organic solvent | B1 | 15 | 15 | 15 | 15 | 15 |
| | | | B'1 | | | | | |
| | | Antirust agent | C1 | | | 1 | 1 | |
| | | Alkaline component | D1 | | 0.09 | 3 | 3 | 3 |
| | | Water | | Balance | Balance | Balance | Balance | Balance |
| | pH | | | 7.1 | 12.9 | 13.8 | 13.3 | 13.6 |
| Evaluation results | (1) Removal | (1-1) Removability | Evaluation | Poor | Poor | Poor | Good | Good |
| | | | Removal time (sec) | Non-removable | 220 | 184 | 104 | 92 |
| | | (1-2) Subdividing | Evaluation | Poor | Good | Poor | Good | Good |
| | | | Removed piece size (mm) | Non-removable | 5 | 6 | 3 | 5 |
| | (2) Low Foamability | | Evaluation | Good | Good | Good | Poor | Poor |
| | | | Foam height (mm) | 9 | 7 | 2 | 14 | 26 |
| | (3) Stability | | Evaluation | Good | Good | Good | Poor | Poor |

**Table 8**

| Remark | | | | Comp. Ex. 6 | Comp. Ex. 7 | Comp. Ex. 8 |
|---|---|---|---|---|---|---|
| Removal agent No. | | | | 26 | 27 | 28 |
| Removal agent | Component | Compound of formula (1) | A1 | 1 | 1 | 1 |
| | | | A'1 | | | |
| | | Organic solvent | B1 | 55 | | |
| | | | B'1 | | 15 | |
| | | Antirust agent | C1 | 1 | | 1 |
| | | Alkaline component | D1 | 3 | 3 | 3 |
| | | Water | | Balance | Balance | Balance |
| | pH | | | 13.5 | 13.6 | 13.5 |
| Evaluation results | (1) Removal | (1-1) Removability | Evaluation | Poor | Good | Poor |
| | | | Removal time (sec) | 162 | 115 | 152 |
| | | (1-2) Subdividing | Evaluation | Poor | Poor | Poor |
| | | | Removed piece size (mm) | 7 | 10 | 12 |
| | (2) Low Foamability | | Evaluation | Excellent | Poor | Good |
| | | | Foam height (mm) | 4 | 11 | 7 |
| | (3) Stability | | Evaluation | Poor | Good | Poor |

As is obvious from Tables 4 to 8, a removal agent containing the component (A) and component (B) can remove a resin film formed on a circuit board in a short period of time, has a high efficiency of subdividing the resin film, and has a low foaming, thus has low environmental impact.

This application is entitled to and claims the benefit of Japanese Patent Application No. 2021-104677 filed on June 24, 2021, the disclosure of which including the claims and specification is incorporated herein by reference in its entirety.

### Industrial Applicability

The present invention can provide removal agents capable of removing a resin film formed on a circuit board in a short period of time, having high efficiency of subdividing the resin film, and having low environmental impact. The present invention is expected to contribute to shortening the production time and reducing the production load of electronic circuit components, and to bring about further development in each field that uses electronic circuit components.

## Claims

1. A removal agent for a circuit board resin film, the removal agent comprising:
a compound (component (A)) represented by formula (1):
R¹-O-(A¹O)a-H ... formula (1)
wherein, R¹ represents a branched alkyl group having 6 to 10 carbon atoms, A¹O represents an oxyalkylene group having 2 to 3 carbon atoms, and a representing an average addition mole number of the oxyalkylene group is 2 or more and 15 or less; and
an aliphatic alcohol (component (B)) having 1 to 6 carbon atoms and a molecular weight of 30 or more and 120 or less,
wherein
pH of the removal agent is 13.0 or more and less than 14.0, and
based on a total mass of the removal agent, a content of the component (A) is 0.1 mass% or more and 5 mass% or less, and a content of the component (B) is 5 mass% or more and 40 mass% or less.

2. The removal agent according to claim 1, further comprising:
an antirust agent (component (C)), wherein a content of the component (C) based on the total mass of the removal agent is 0.5 mass% or more and 2 mass% or less.

3. The removal agent according to claim 2, wherein the antirust agent is a compound represented by formula (2): 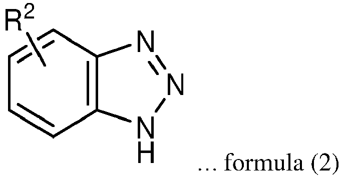 wherein R² represents a hydrogen atom, a methyl group, or a carboxyl group.

4. A method for producing a circuit board, the method comprising:
preparing a circuit board with a resin film formed on at least one surface thereof; and
bringing the removal agent according to any one of claims 1 to 3 into contact with the resin film.
